# EUROPÄISCHE PATENTSCHRIFT

(11) **EP 4 526 629 B1**
(45) Veröffentlichungstag und Bekanntmachung des Hinweises auf die Patenterteilung: **09.09.2026**
(21) Anmeldenummer: 23724757.2
(22) Anmeldetag: 03.05.2023
(51) Int. Cl.: G01F 1/58, G01F 1/60, G01F 1/684, G01F 1/696, H05K 3/46, H05K 1/18, H05K 1/16, H05K 1/02, H05K 1/181

(54) **SENSORANORDNUNG MIT INTEGRIERTER ELEKTRONIK**
SENSOR ARRANGEMENT WITH INTEGRATED ELECTRONICS
AGENCEMENT DE CAPTEUR À ÉLECTRONIQUE INTÉGRÉE

(30) Priorität: 18.05.2022 DE 102022204944
(43) Veröffentlichungstag der Anmeldung: 26.03.2025
(73) Patentinhaber: VOLKSWAGEN AKTIENGESELLSCHAFT, 38440 Wolfsburg (DE)
(72) Erfinder: SCHILLER, Heino, 38122 Braunschweig (DE); STUTZ, Simon, 37181 Hardegsen (DE); GEISLER, Paul, 38114 Braunschweig (DE); KRUSE, Tom, 37581 Bad Gandersheim (DE); MAUE, Sven, 38338 Salzgitter (DE)
(74) Vertreter: RGTH
(86) Internationale Anmeldenummer: PCT/EP2023/061715
(87) Internationale Veröffentlichungsnummer: WO 2023/222388

(56) Entgegenhaltungen:
- EP-B1- 2 727 132
- US-A1- 2018 093 042
- US-B2- 7 137 307

## Beschreibung

Die Erfindung betrifft eine Sensoranordnung, aufweisend einen Sensorabschnitt mit mindestens einem Sensor und aufweisend mindestens einen Elektronikabschnitt mit einer Elektronik zum Ansteuern und/oder Auslesen des mindestens einen Sensors, wobei der mindestens eine Sensor elektrisch mit der mindestens einen Elektronik verbunden ist. Des Weiteren betrifft die Erfindung ein Fluidsystem.

Zur Regelung und Diagnose des Kühlkreislaufs eines Fahrzeugs werden üblicherweise verschiedene Sensoren und Aktoren benötigt, durch deren Vielzahl die Komplexität des Thermomanagement-Systems des Fahrzeugs erhöht wird. Hierbei werden die jeweiligen Aktoren und Sensoren, wie beispielsweise Heizelemente, Temperatursensoren und Durchflusssensoren, regulär als separate Bauteile ausgeführt und einzeln an unterschiedlichen Einbaupositionen im Fahrzeug verbaut. Durch die Vielzahl an Messstellen aufgrund der unterschiedlichen Einbaupositionen steigt auch die Komplexität des Thermomanagement-Systems.

In der US 2014/0192483 A1 wird eine Anordnung beschrieben, die in Flex-Leiterplatten Technologie gefertigt ist. Eine flexible Leiterplatte kann bei Bedarf auf eine passiv oder aktiv gekühlte Rolle aufgewickelt oder von dieser Rolle abgewickelt werden.

Die US 5,818,692 A beschreibt eine flexible Leiterplatte mit Fluidkanälen, in welchen elektronische Komponenten angeordnet sind. Die Fluidkanäle können mit einem Kühlkreislauf verbunden werden, um die elektronischen Komponenten mit dem Kühlmittel zu umströmen.

Aus der WO 2021/140018 A1 ist eine Heizvorrichtung zur Erzeugung von Aerosolen bekannt. Der Heizer ist auf einem ersten Abschnitt der flexiblen Leiterplatte und eine Ansteuerungselektronik auf einem zweiten Abschnitt der flexiblen Leiterplatte angeordnet.

Die EP 2 850 956 B1 beschreibt eine Heizvorrichtung, bei der eine Heizspirale zusammen mit Wärmereflektionselementen auf einer flexiblen Folie angeordnet ist. Durch ein Aufwickeln der flexiblen Folie zu einem Rohr können die Heizspirale innenseitig und die Wärmereflektionselemente außenseitig des Rohrs ausgerichtet werden.

Weiterhin beschreibt die US 2015/0305146 A1 eine Anordnung mit einem flexiblen und dehnbaren Substrat, die im Bereich der Elektrotechnik nutzbar ist. Es wird insbesondere auf den Einsatz in intelligenten Kleidungsstücken hingewiesen.

Aus der US 2018/093042 A1 ist Sensor bekannt zur kapazitiven Bestimmung eines Füllstands einer mit einer flüssigen Substanz gefüllten Kartusche. Der Sensor besteht aus einer ebenen, flexiblen Folie, die am Außenumfang eines röhrenförmigen Zylinders der Patrone angeordnet werden kann.

Die EP 2 727 132 B1 offenbart ein System und ein Verfahren zum Bereitstellen eines MEMS-Geräts mit integrierter Elektronik. Das MEMS-Gerät umfasst ein integriertes Schaltungssubstrat und eine mit dem integrierten Schaltungssubstrat gekoppelte MEMS-Unterbaugruppe. Das integrierte Schaltungssubstrat umfasst mindestens eine Schaltung, die mit mindestens einer festen Elektrode gekoppelt ist. Die MEMS-Unterbaugruppe umfasst mindestens einen durch einen lithografischen Prozess gebildeten Abstandshalter, eine flexible Platte mit einer Ober- und einer Unterseite sowie eine MEMS-Elektrode, die mit der flexiblen Platte und elektrisch mit dem mindestens einen Abstandshalter verbunden ist.

Die US 7 137 307 B2 offenbart eine magnetisch-induktive Messvorrichtung für strömende Substanzen, mit jeweils mindestens einem Teilsystem zur Stoffführung, zur Messsignalerfassung, bestehend aus einem Signalaufnehmer zur Erzeugung eines magnetischen Feldes, bestehend aus mindestens zwei Erregerspulen und einem ferromagnetischen Kern, und zur umgebungsseitigen Begrenzung.

Die bekannten Lösungen sind für den Einsatz in einem Fahrzeugumfeld nicht ausgelegt und können insbesondere die Komplexität bestehender Thermomanagement-Systeme nicht reduzieren.

Der Erfindung liegt die Aufgabe zugrunde, eine Sensoranordnung zu schaffen, durch welche die Komplexität und die Bauteilvielfalt bestehender Thermomanagement-Systeme im Fahrzeug verringert werden. Diese Aufgabe wird durch die im Anspruch 1 angegebenen Merkmale gelöst. Weitere vorteilhafte Ausgestaltungen der Erfindung sind in den Unteransprüchen beschrieben.

Gemäß einem Aspekt der Erfindung wird eine Sensoranordnung bereitgestellt. Die Sensoranordnung weist einen Sensorabschnitt mit mindestens einem Sensor und mindestens einen Elektronikabschnitt mit einer Elektronik zum Ansteuern und/oder Auslesen des mindestens einen Sensors auf. Der mindestens eine Sensor ist elektrisch mit der mindestens einen Elektronik verbunden. Erfindungsgemäß ist der Elektronikabschnitt auf einer starren Leiterplatte angeordnet. Der Sensorabschnitt ist auf einer flexiblen Leiterplatte angeordnet oder ist in Form einer flexiblen Leiterplatte ausgebildet.

Durch die erfindungsgemäße Sensoranordnung kann eine Sensorik, insbesondere für die Integration in einen Kühlkreislauf, mit einer entsprechenden Auswerteelektronik kombiniert werden.

Durchflusssensoren sind üblicherweise kostenintensiv in der Herstellung, sodass der Einbau derartiger Sensoren in fahrzeugseitigen Kühlsystemen vermieden wird. Die erfindungsgemäße Sensoranordnung kann in Form eines Durchflusssensors ausgestaltet sein, welcher preiswert in der Herstellung ist und technisch einfach in das Kühlsystem bzw. ein beliebiges Fluidsystem einsetzbar ist.

Die Sensoranordnung wird in einer sogenannten Starr-Flex-Leiterplatten-Technologie aufgebaut. Die Elektronik bzw. die Leistungselektronik wird dabei auf einer starren Leiterplatte aufgebracht. Die äußeren Leiter bzw. Leiterbahnen der starren Leiterplatte erstrecken sich jedoch in einen flexiblen Teil, die flexible Leiterplatte. Diese Leiterbahnen sind dabei derart strukturiert, dass die flexible Leiterplatte beispielsweise direkt als Heizelement oder als ein Sensor dienen kann. Dabei können mehrere Sensoren oder Aktoren innerhalb der flexiblen Leiterplatte ausgestaltet sein.

Somit können mehrere Bauteile in eine erfindungsgemäße Sensoranordnung integriert werden. Auf diese Weise lassen sich kostengünstig beispielsweise Temperatur- Druck- oder Strömungssensoren integrieren, die für die Regelung des Fluidsystems erforderlich sein können. Diese Größen können eine genauere Regelung des Fluidsystems erlauben oder die Diagnosefähigkeit erhöhen. Beispielsweise kann eine Plausibilisierung einer Pumpen-Drehzahl und eines gemessenen Volumenstroms umgesetzt werden. Dies kann direkt während des Betriebs des Fluidsystems realisiert werden, wobei aufgrund der Bauweise der Sensoranordnung alle Messgrößen an einer im Wesentlichen gemeinsamen Position ermittelt werden und die Komplexität bei der Auswertung der Messdaten durch die Elektronik verringert ist.

Darüber hinaus können weitere Sensoren in die flexible Leiterplatte integriert werden, die der Diagnostik des Mediums dienen. Derartige Sensoren können für Leitfähigkeitsmessungen und/oder für die Impedanz-Spektroskopie verwendet werden.

Der Sensorabschnitt kann somit vollständig als eine flexible Leiterplatte ausgestaltet sein und einen oder mehrere Sensoren umfassen. Die Sensoranordnung kann als eine fahrzeugseitige Sensoranordnung ausgestaltet sein. Insbesondere kann mindestens eine Sensoranordnung in einem fahrzeugseitigen Fluidsystem, beispielsweise einem Kühlsystem, positioniert sein.

Die Sensoranordnung kann vielseitig eingesetzt werden, wenn diese mindestens einen Einwirkungsabschnitt aufweist, welcher zum Sensorabschnitt benachbart angeordnet ist. Erfindungsgemäß ist der mindestens eine Einwirkungsabschnitt als eine elektrische Heizung und/oder bevorzugt als mindestens eine Spule zur Magnetfelderzeugung ausgestaltet. Hierbei ist Elektronik dazu eingerichtet, die elektrische Heizung und/oder die mindestens eine Spule kontinuierlich oder zeitweise oder getaktet anzusteuern. Die konventionellen Messsysteme von Kühlkreisläufen bestehen aus verschiedenen Bauteilen. Durch die Ausgestaltung der Sensoranordnung können Steckverbinder und Einbaupositionen für verschiedene Komponenten eingespart werden. Diese Maßnahmen resultieren in verringerten Kosten und einem reduzierten Montageaufwand.

Beispielsweise enthalten konventionelle Heizer hohe Anteile an Metall. Diese stellen einerseits ein zusätzliches Gewicht im Fahrzeug dar und andererseits eine thermische Masse, welche die Aufheizzeit verlängert und zu einem Nachheizen führen kann. Diese Nachteile können durch die erfindungsgemäße Sensoranordnung vermieden werden, da ein Heizelement innerhalb des Einwirkungsabschnitts als flexible Leiterbahnen aus einer Kupferbeschichtung oder Kupferfolie ausgestaltet sein kann.

Gemäß einem weiteren Ausführungsbeispiel ist der mindestens eine Einwirkungsabschnitt neben dem Sensorabschnitt in die flexible Leiterplatte integriert. Alternativ sind mehrere Einwirkungsabschnitte mit mehreren Sensorabschnitten abwechselnd in die flexible Leiterplatte integriert. Durch diese Maßnahmen können unterschiedlich ausgestaltete Messsysteme, wie beispielsweise Hallsensoren, kosteneffizient und kompakt bzw. platzsparend umgesetzt werden.

Die Sensoranordnung kann vielseitig eingesetzt werden, wenn der mindestens eine Sensor des Sensorabschnitts als ein kapazitiver Sensor, als ein resistiver Sensor, als mindestens eine Sensorelektrode und/oder als ein Leitfähigkeitssensor ausgestaltet ist. Beispielsweise kann die flexible Leiterplatte bzw. die entsprechende Folie diskrete Sensorelemente enthalten oder selbst einen Teil eines oder mehrerer Sensoren darstellen. Somit können Eigenschaften des Mediums direkt und kostengünstig erfasst werden. Vorzugsweise kann die flexible Leiterplatte in das Medium bzw. das Fluid des Fluidsystems hineinragen bzw. in Kontakt mit diesem stehen.

Gemäß einer vorteilhaften Ausgestaltung können auch Heißfilm-Durchflussmesser durch die erfindungsgemäße Sensoranordnung realisiert werden.

Nach einer weiteren Ausführungsform ist die flexible Leiterplatte zu einer Spirale oder zu einem Rohr gewickelt. Durch das Aufwickeln der flexiblen Leiterplatte zu einer Spirale kann eine aktive Fläche des Sensorabschnitts und/oder des Einwirkungsabschnitts vergrößert werden. Darüber hinaus können durch diese Maßnahme turbulente Strömungen erzeugt werden, die eine optimale Wärmeübertragung an das umgebende Medium ermöglichen.

Ein rohrförmiger Aufbau der flexiblen Leiterplatte ermöglicht die wandseitige Auskleidung eines Fluidkanals, durch welchen eine möglichst geringe Wechselwirkung der Sensoranordnung mit dem Fluid bzw. Medium erzielt wird. Somit kann die Sensoranordnung je nach Anforderung in Richtung einer verstärkten oder einer minimierten Wechselwirkung mit dem Fluid konstruiert werden.

Darüber hinaus sind auch weitere Geometrien der flexiblen Leiterplatte möglich. Beispielsweise kann ein als eine Heizfolie ausgestalteter Einwirkungsabschnitt kompakt aufgefaltet werden. So kann die flexible Leiterplatte beispielsweise zu einer Z-Form, einer W-Form, einer L-Form und dergleichen gebogen sein, um eine optimale Ausrichtung innerhalb eines Fluidkanals zu erzielen.

Gemäß einem weiteren Ausführungsbeispiel weist die flexible Leiterplatte eine Versteifungsstruktur und/oder Abstandselemente auf, welche dazu eingerichtet sind, die flexible Leiterplatte in einer gebogenen und/oder gewickelten Form zu halten. Vorzugsweise können derartige Versteifungsstrukturen und/oder Abstandselemente aus einem elektrisch isolierenden Material bestehen oder elektrisch isoliert sein. Durch diese Maßnahme kann eine gleichbleibende Geometrie und eine ortsfeste Position der flexiblen Leiterplatte erzielt werden.

Die Sensoranordnung kann besonders optimal in ein Fluidsystem integriert werden, wenn die flexible Leiterplatte dazu eingerichtet ist, innerhalb eines Fluids mit einer Strömungsrichtung angeordnet zu sein. Vorzugweise ist die flexible Leiterplatte derart ausrichtbar, dass die Strömungsrichtung parallel zu einer flächigen Ausdehnung der flexiblen Leiterplatte verläuft. Hierdurch wird eine optimale Anströmung des mindestens einen Sensors und/oder des mindestens einen Aktors im Einwirkungsabschnitt, wie beispielsweise eines Heizelements, ermöglicht.

Nach einer weiteren Ausführungsform ist die flexible Leiterplatte im Wesentlichen zu einem Rohr oder einem Rohrsegment gebogen, wobei mindestens zwei sich gegenüberliegende Einwirkungsabschnitte zur Erzeugung eines Magnetfelds auf der flexiblen Leiterplatte angeordnet sind. Mindestens zwei Sensorabschnitte sind zur Messung einer Hallspannung vorgesehen, wobei die Sensorabschnitte um 90° zu den Einwirkungsabschnitten um eine Strömungsrichtung des Fluids gedreht sind.

Beispielsweise können in die spiralförmig aufgewickelte Heizfolie zusätzlich Spulen und Elektroden strukturiert werden, die im aufgewickelten Zustand orthogonal zueinander angeordnet sind. Die Heizfolie ist dabei Bestandteil eines Einwirkungsabschnitts oder mehrerer Einwirkungsabschnitte. Die Spulen können hierbei als Sensorspulen im Bereich von mindestens einem Sensorabschnitt oder als Aktorspulen zur Erzeugung von Magnetfeldern in mindestens einem Einwirkungsabschnitt angeordnet sein. Mit den Spulen kann mittels eines elektrischen Stroms ein näherungsweise homogenes Magnetfeld erzeugt werden, das ein leitfähiges Medium, welches dieses Magnetfeld durchströmt, ablenkt. Diese Ablenkung der Strömung kann mittels der zusätzlichen Elektroden resistiv oder kapazitiv gemessen werden. So lässt sich ein magnetisch-induktiver Durchflussmesser umsetzen, mit dem der Volumenstrom des Mediums bestimmt werden kann.

Die Sensoranordnung kann fluiddicht in das Fluidsystem eingebracht werden, wenn die flexible Leiterplatte und die starre Leiterplatte durch einen Verbindungsabschnitt mechanisch und elektrisch miteinander verbunden sind. Dabei kann der Verbindungsabschnitt als eine flexible Leiterplatte oder als eine starre Leiterplatte ausgestaltet sein.

Gemäß einem weiteren Aspekt der Erfindung wird ein Fluidsystem bereitgestellt. Das Fluidsystem weist mindestens ein strömendes Fluid auf, welches durch einen Fluidkanal mit einer Strömungsrichtung strömt. Das Fluidsystem weist mindestens eine erfindungsgemäße Sensoranordnung auf, wobei die flexible Leiterplatte der Sensoranordnung zumindest bereichsweise innerhalb des Fluidkanals angeordnet ist. Hierdurch kann eine integrierte Anordnung mit mehreren Sensoren und/oder Aktoren mit einer entsprechenden Elektronik kombiniert in das Fluidsystem eingebracht werden. Beispielsweise können Heizelemente mit Messelektroden zur Leitfähigkeitsmessung kombiniert innerhalb der flexiblen Leiterplatte strukturiert werden, um an einer gemeinsamen Position auf das Fluid einzuwirken und mindestens eine Messgröße zu ermitteln.

Das erfindungsgemäße Fluidsystem kann beispielsweise als ein fahrzeugseitiges Kühlsystem, ein stationäres Kühlsystem, ein Durchlauferhitzer, ein Taschenwärmer, ein industrielles Kreislaufsystem und dergleichen ausgestaltet sein.

Nachfolgend werden Ausführungsbeispiele der Erfindung anhand der Zeichnungen näher erläutert. Es zeigen:
- Fig. 1: eine perspektivische Darstellung einer erfindungsgemäßen Sensoranordnung gemäß einer ersten Ausführungsform,
- Fig. 2: eine Draufsicht auf eine erfindungsgemäße Sensoranordnung gemäß einer zweiten Ausführungsform,
- Fig. 3: eine perspektivische Darstellung der Sensoranordnung aus Fig. 2 in einer zu einer Spirale gerollten Form,
- Fig. 4: eine Schnittdarstellung einer erfindungsgemäßen Sensoranordnung gemäß einer dritten Ausführungsform, und
- Fig. 5: eine schematische Darstellung eines erfindungsgemäßen Fluidsystems gemäß einer Ausführungsform.

In den Figuren weisen dieselben konstruktiven Elemente jeweils dieselben Bezugsziffern auf.

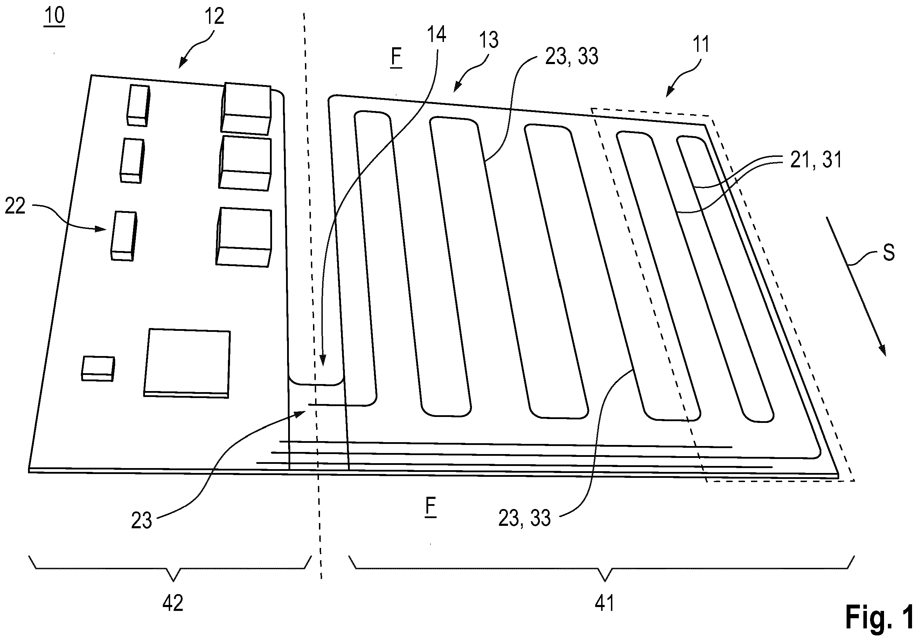

Die Fig. 1 zeigt eine perspektivische Darstellung einer erfindungsgemäßen Sensoranordnung 10 gemäß einer ersten Ausführungsform. Die Sensoranordnung 10 weist im dargestellten Ausführungsbeispiel einen Sensorabschnitt 11 mit einem Sensor 21 und mindestens einen Elektronikabschnitt 12 mit einer Elektronik 22 zum Ansteuern und/oder Auslesen des mindestens einen Sensors 21 auf.

Des Weiteren weist die Sensoranordnung 10 einen Einwirkungsabschnitt 13 auf. Der Einwirkungsabschnitt 13 ist beispielhaft zwischen dem Elektronikabschnitt 12 und dem Sensorabschnitt 11 angeordnet. Auf dem Einwirkungsabschnitt 13 sind elektrische Leiterbahnen 33 angeordnet, die als eine elektrische Heizung 23 fungieren.

Der Sensorabschnitt 11 weist elektrische Leiterbahnen 31 auf, welche als ein kapazitiver Sensor 21 fungieren. Dabei sind die elektrischen Leiterbahnen 31 im Sensorabschnitt 11 und die elektrischen Leiterbahnen 33 im Einwirkungsabschnitt 13 im dargestellten Ausführungsbeispiel beidseitig elektrisch isoliert und haben keinen direkten Kontakt zu einem umgebenden Medium oder Fluid F.

Der Einwirkungsabschnitt 13 und der Sensorabschnitt 11 sind auf einer flexiblen Leiterplatte 41 angeordnet. Der Elektronikabschnitt 12 ist auf einer starren Leiterplatte 42 angeordnet. Neben der Ansteuerung und Auswertung des Sensors 31 auf den Sensorabschnitt 11 übernimmt die Elektronik 22 auch die Ansteuerung und Regelung der Komponenten im Einwirkungsabschnitt 13. Im dargestellten Ausführungsbeispiel steuert die Elektronik 22 die elektrische Heizung 23.

Darüber hinaus ist ein Verbindungsabschnitt 14 vorgesehen, welcher die flexible Leiterplatte 41 mit dem Einwirkungsabschnitt 13 und dem Sensorabschnitt 11 und die starre Leiterplatte 42 mit dem Elektronikabschnitt 12 mechanisch und elektrisch miteinander verbindet.

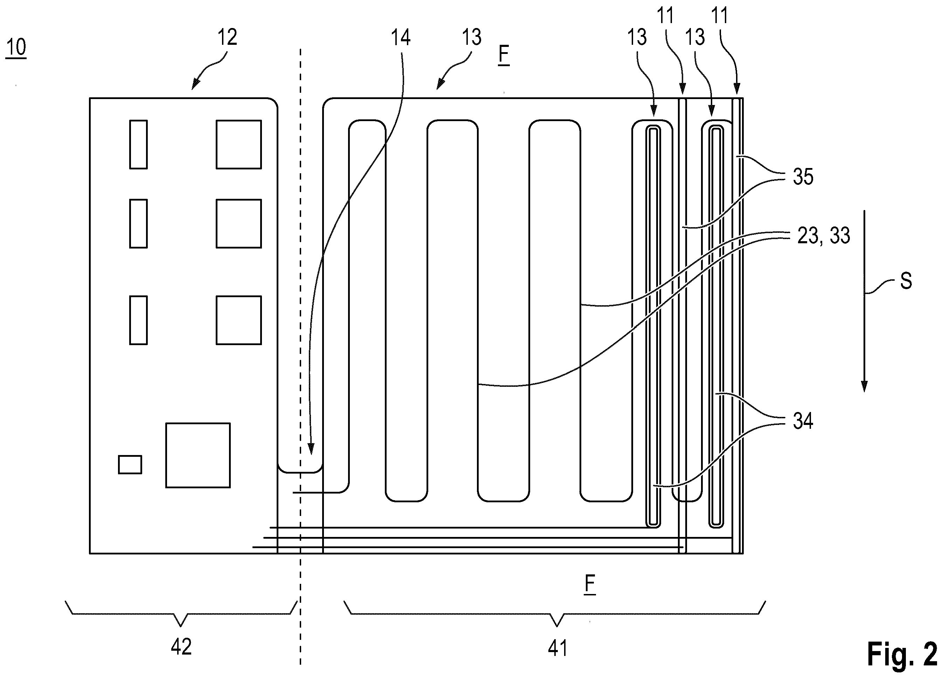

Die Fig. 2 zeigt eine Draufsicht auf eine erfindungsgemäße Sensoranordnung 10 gemäß einer zweiten Ausführungsform. Im Gegensatz zur in Fig. 1 beschriebenen Sensoranordnung 10 sind mehrere Einwirkungsabschnitte 13 vorgesehen, die sich mit mehreren Sensorabschnitten 11 abwechseln.

An einer dem Elektronikabschnitt 12 abgewandten Seite der flexiblen Leiterplatte sind im Anschluss an die elektrische Heizung 23 abwechselnd elektromagnetische Erregerwicklungen 34 und Sensorelektroden 35 angeordnet. Die Sensorelektroden 35 sind in Sensorabschnitten 11 und die elektromagnetischen Erregerwicklungen 34 in Einwirkungsabschnitten 13 angeordnet. Dabei sind die Sensorelektroden 35 und die elektromagnetischen Erregerwicklungen 34 derart zueinander auf der flexiblen Leiterplatte angeordnet und ausgerichtet, dass in einem zusammengerollten Zustand die beiden elektromagnetischen Erregerwicklungen 34 einander zugewandt und die beiden Sensorelektroden 35 ebenfalls einander zugewandt sind. Dabei sind die Sensorelektroden 35 um 90° gegenüber den elektromagnetischen Erregerwicklungen 34 gedreht positioniert, um einen magnetischinduktiven Durchflussmesser umsetzen.

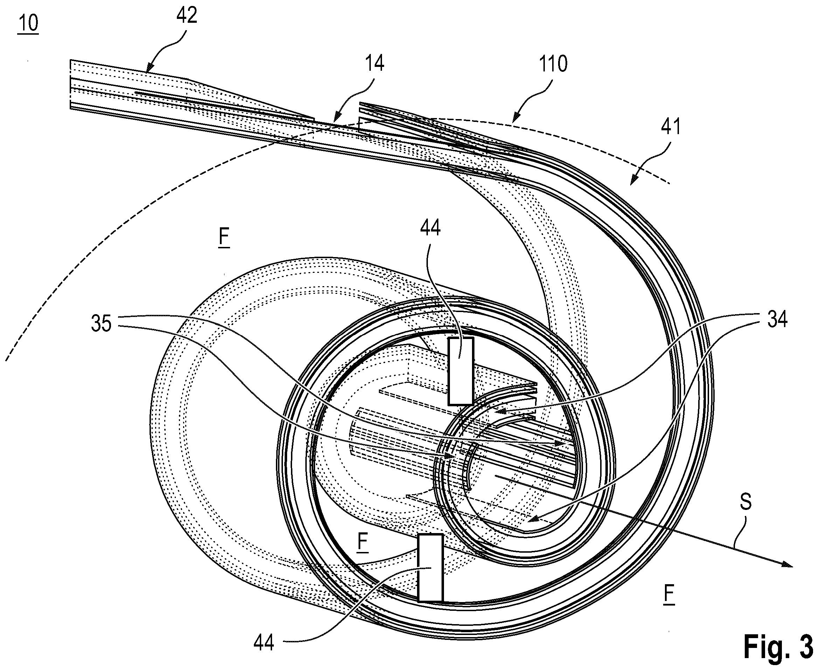

Die jeweiligen Sensorabschnitte 11 und Einwirkungsabschnitte 13 sind um eine Flussrichtung bzw. Strömungsrichtung S des Fluids F um 90° versetzt angeordnet. Die Fig. 3 verdeutlicht die Sensoranordnung 10 und die Ausrichtung der elektromagnetischen Erregerwicklungen 34 und der Sensorelektroden 35 zueinander in einem zu einer Spirale aufgerollten Zustand. Das Fluid F kann parallel zu der flächigen Ausdehnung der flexiblen Leiterplatte entlang der Strömungsrichtung S strömen. Insbesondere kann ausschließlich die flexible Leiterplatte in das Fluid F eingetaucht sein. Der Verbindungsabschnitt 14 kann in eine nicht dargestellte Durchführung eingebracht sein und somit einen fluidführenden Abschnitt mit einem nichtfluidführenden Abschnitt eines Fluidsystems 100 elektrisch verbinden.

Im dargestellten Ausführungsbeispiel sind die Sensorelektroden 35 zumindest bereichsweise ohne eine elektrische Isolierung (nicht dargestellt) angeordnet und weisen somit einen direkten Kontakt zum Fluid F auf. Die Sensorelektroden 35 sind somit als resistive Sensoren oder als Sensoren zur Leitfähigkeitsmessung ausgestaltet.

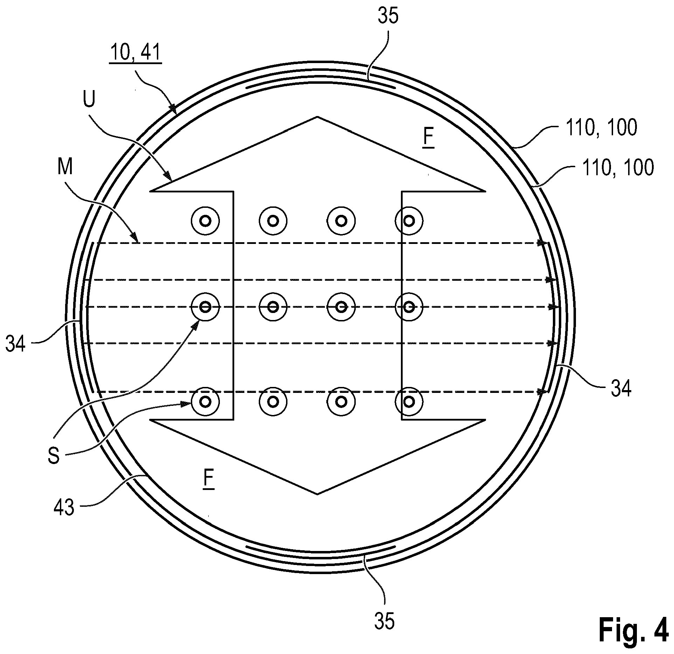

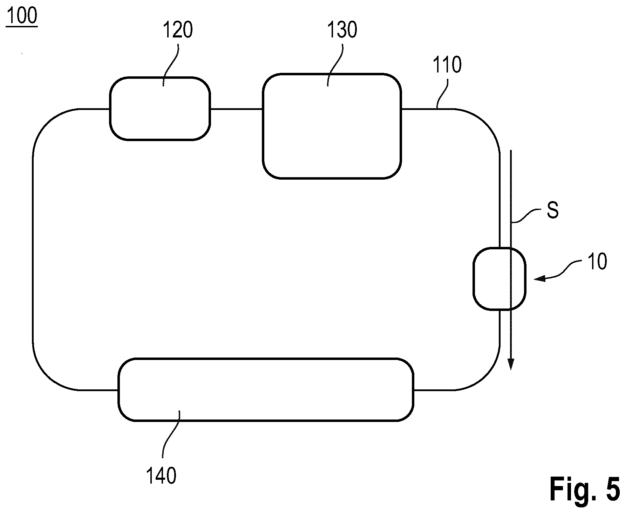

Die Fig. 4 zeigt eine Schnittdarstellung einer erfindungsgemäßen Sensoranordnung 10 gemäß einer dritten Ausführungsform. Dabei veranschaulicht die Fig. 4 das Prinzip und die Funktionsweise der Sensoranordnung 10 aus Fig. 2 und Fig. 3. Im Unterschied zum in Fig. 3 dargestellten Ausführungsbeispiel ist die flexible Leiterplatte der Sensoranordnung 10 zu einem Rohr gerollt. Somit kann die Sensoranordnung 10 beispielsweise einen Fluidkanal 110 eines in Fig. 5 gezeigten Fluidsystems 100 innenseitig auskleiden.

Die elektromagnetischen Erregerwicklungen 34 erzeugen ein Magnetfeld mit Magnetfeldlinien M, welche quer zu der Strömungsrichtung S des Fluids verlaufen. Eine resultierende Hall-Spannung U wird durch das Magnetfeld M im Fluid F verursacht. Diese Hall-Spannung U ist abhängig von einer Strömungsgeschwindigkeit der Strömung entlang der Strömungsrichtung S und wird durch die Sensorelektroden 35 gemessen. Die entsprechenden Messdaten können von der Elektronik 22 empfangen und ausgewertet werden.

Der Übersicht halber sind der Verbindungsabschnitt 14 und der Elektronikabschnitt 12 der Sensoranordnung 10 nicht dargestellt.

Zur Gewährleistung der gerollten Form der flexiblen Leiterplatte 41 können Versteifungsstrukturen 43 verwendet werden. Beispielsweise kann eine Spiralfeder oder ein Rohrabschnitt als eine Versteifungsstruktur 43 fungieren. Darüber hinaus können Abstandselemente 44 vorgesehen sein, um beispielsweise eine Spiralform, wie in Fig. 3 gezeigt, zu gewährleisten.

In der Fig. 5 ist eine schematische Darstellung eines erfindungsgemäßen Fluidsystems 100 gemäß einer Ausführungsform gezeigt. Das Fluidsystem 100 ist im dargestellten Ausführungsbeispiel als ein fahrzeugseitiges Kühlsystem ausgestaltet. Dabei ist das Fluidsystem 100 stark vereinfacht illustriert und weist einen Fluidkanal 110 auf, durch welchen ein Fluid F, wie beispielsweise ein flüssiges Kühlmittel gefördert wird.

Eine Kühlmittelpumpe 120 fördert das Fluid F durch den Fluidkanal 110, um Wärme von einem Wärmeerzeuger 130, wie beispielsweise einem Verbrennungsmotor oder einer Leistungselektronik, zu einer Wärmesenke 140, wie beispielsweise einem Umgebungswärmetauscher, zu transportieren.

Die Sensoranordnung 10 ist in den Fluidkanal 110 integriert. Dabei ist die flexible Leiterplatte 41 mit dem Sensorabschnitt 11 und optional mit dem Einwirkungsabschnitt 13 in dem Fluidkanal 110 angeordnet und die starre Leiterplatte 42 mit dem Elektronikabschnitt 12 außerhalb des Fluidkanals 110 angeordnet.

Der Einwirkungsabschnitt 13 ist dazu eingerichtet, auf das Fluid F im Fluidkanal 110, beispielsweise in Form einer Wärmeeinwirkung oder einer elektromagnetischen Einwirkung, einzuwirken.

Der Sensorabschnitt 11 ist dazu eingerichtet, mindestens einen Parameter des Fluids F innerhalb des Fluidkanals 110 zu messen.

### Bezugszeichenliste

- 100: Kraftfahrzeug
- 110: Fluidkanal
- 120: Kühlmittelpumpe / Fluidpumpe
- 130: Wärmeerzeuger
- 140: Wärmesenke

- 10: Sensoranordnung
- 11: Sensorabschnitt
- 12: Elektronikabschnitt
- 13: Einwirkungsabschnitt
- 14: Verbindungsabschnitt

- 21: Sensor / kapazitiver Sensor
- 22: Elektronik
- 23: elektrische Heizung

- 31: elektrische Leiterbahnen des kapazitiven Sensors
- 33: elektrischen Leiterbahnen der elektrischen Heizung
- 34: elektromagnetische Erregerwicklung
- 35: Sensorelektrode

- 41: flexible Leiterplatte
- 42: starre Leiterplatte
- 43: Versteifungsstruktur
- 44: Abstandselement

- F: Fluid
- M: Magnetfeld
- S: Strömungsrichtung des Fluids
- U: Hall-Spannung

## Patentansprüche

1. Sensoranordnung (10), aufweisend einen Sensorabschnitt (11) mit mindestens einem Sensor (21) und aufweisend mindestens einen Elektronikabschnitt (12) mit einer Elektronik (22) zum Ansteuern und/oder Auslesen des mindestens einen Sensors (21), wobei der mindestens eine Sensor (21) elektrisch mit der mindestens einen Elektronik (22) verbunden ist, wobei der Elektronikabschnitt (12) auf einer starren Leiterplatte (42) angeordnet ist, und wobei der Sensorabschnitt (11) auf einer flexiblen Leiterplatte (41) angeordnet oder in Form einer flexiblen Leiterplatte (41) ausgebildet ist,
**dadurch gekennzeichnet, dass**
die Sensoranordnung (10) mindestens einen Einwirkungsabschnitt (13) aufweist, welcher zum mindestens einen Sensorabschnitt (11) benachbart angeordnet ist, wobei der mindestens eine Einwirkungsabschnitt (13) als eine elektrische Heizung (23) ausgestaltet ist, wobei die Elektronik (22) dazu eingerichtet ist, die elektrische Heizung (23) kontinuierlich oder zeitweise oder getaktet anzusteuern.

2. Sensoranordnung nach Anspruch 1, wobei der mindestens eine Einwirkungsabschnitt (13) als eine elektrische Heizung (23) und als mindestens eine Spule (34) zur Magnetfelderzeugung ausgestaltet ist, wobei die Elektronik (22) dazu eingerichtet ist, die elektrische Heizung (23) und die mindestens eine Spule (34) kontinuierlich oder zeitweise oder getaktet anzusteuern.

3. Sensoranordnung nach Anspruch 2, wobei der mindestens eine Einwirkungsabschnitt (13) neben dem Sensorabschnitt (11) in die flexible Leiterplatte (41) integriert ist; oder mehrere Einwirkungsabschnitte (13) sich mit mehreren Sensorabschnitten (11) abwechselnd in die flexible Leiterplatte (41) integriert oder auf der flexiblen Leiterplatte (41) angeordnet sind.

4. Sensoranordnung nach einem der Ansprüche 1 bis 3, wobei der mindestens eine Sensor (21) als ein kapazitiver Sensor, als ein resistiver Sensor, als mindestens eine Sensorelektrode und/oder als ein Leitfähigkeitssensor ausgestaltet ist.

5. Sensoranordnung nach einem der Ansprüche 1 bis 4, wobei die flexible Leiterplatte (41) zu einer Spirale oder zu einem Rohr gewickelt ist.

6. Sensoranordnung nach einem der Ansprüche 1 bis 5, wobei die flexible Leiterplatte (41) eine Versteifungsstruktur (43) und/oder Abstandselemente (44) aufweist, welche dazu eingerichtet sind, die flexible Leiterplatte (41) in einer gebogenen und/oder gewickelten Form zu halten.

7. Sensoranordnung nach einem der Ansprüche 1 bis 6, wobei die flexible Leiterplatte (41) dazu eingerichtet ist, innerhalb eines Fluids (F) mit einer Strömungsrichtung (S) angeordnet zu sein, wobei die flexible Leiterplatte (41) derart ausrichtbar ist, dass die Strömungsrichtung (S) parallel zu einer flächigen Ausdehnung der flexiblen Leiterplatte (41) verläuft.

8. Sensoranordnung nach einem der Ansprüche 1 bis 7, wobei die flexible Leiterplatte (41) im Wesentlichen zu einem Rohr oder einem Rohrsegment gebogen ist, wobei mindestens zwei sich gegenüberliegende Einwirkungsabschnitte (13) zur Erzeugung eines Magnetfelds (M) auf der flexiblen Leiterplatte (41) angeordnet sind, wobei um 90° zu den Einwirkungsabschnitten (13) um eine Strömungsrichtung (S) gedreht mindestens zwei Sensorabschnitte (11) zur Messung einer Hallspannung (U) vorgesehen sind.

9. Sensoranordnung nach einem der Ansprüche 1 bis 8, wobei die flexible Leiterplatte (41) und die starre Leiterplatte (42) durch einen Verbindungsabschnitt (14) mechanisch und elektrisch miteinander verbunden sind, wobei der Verbindungsabschnitt (14) flexibel oder starr ausgestaltet ist.

10. Fluidsystem (100), aufweisend mindestens ein strömendes Fluid (F), welches durch einen Fluidkanal (110) mit einer Strömungsrichtung (S) strömt, und aufweisend mindestens eine Sensoranordnung (10) gemäß einem der vorhergehenden Ansprüche, wobei die flexible Leiterplatte (41) der Sensoranordnung (10) zumindest bereichsweise innerhalb des Fluidkanals (110) angeordnet ist.

## Claims

1. Sensor arrangement (10) having a sensor section (11) with at least one sensor (21) and having at least one electronics section (12) with electronics (22) for driving and/or reading out the at least one sensor (21), wherein the at least one sensor (21) is electrically connected to the at least one electronics (22), wherein the electronics section (12) is arranged on a rigid printed circuit board (42), and wherein the sensor section (11) is arranged on a flexible printed circuit board (41) or is formed as a flexible printed circuit board (41), **characterized in that**
the sensor arrangement (10) has at least one actuation section (13) which is arranged adjacent to the at least one sensor section (11), wherein the at least one actuating section (13) is configured as an electric heater (23), wherein the electronics (22) is configured to drive the electric heater (23) continuously, intermittently, or in a clocked manner.

2. Sensor arrangement according to claim 1, wherein the at least one actuation section (13) is configured as an electric heater (23) and as at least one coil (34) for generating a magnetic field, wherein the electronics (22) is configured to drive the electric heater (23) and the at least one coil (34) continuously, intermittently, or in a clocked manner.

3. Sensor arrangement according to claim 2, wherein the at least one actuation section (13) is integrated into the flexible printed circuit board (41) alongside the sensor section (11); or several actuation sections (13) are integrated into the flexible printed circuit board (41) alternately with several sensor sections (11) or are arranged on the flexible printed circuit board (41).

4. Sensor arrangement according to one of claims 1 to 3, wherein the at least one sensor (21) is configured as a capacitive sensor, as a resistive sensor, as at least one sensor electrode, and/or as a conductivity sensor.

5. Sensor arrangement according to one of claims 1 to 4, wherein the flexible printed circuit board (41) is wound into a spiral or a tube.

6. Sensor arrangement according to one of claims 1 to 5, wherein the flexible printed circuit board (41) has a bracing structure (43) and/or spacer elements (44) which are configured to hold the flexible printed circuit board (41) in a bent and/or coiled shape.

7. Sensor arrangement according to one of claims 1 to 6, wherein the flexible printed circuit board (41) is configured to be arranged within a fluid (F) with a flow direction (S), wherein the flexible printed circuit board (41) can be oriented such that the flow direction (S) runs parallel to a planar extension of the flexible printed circuit board (41).

8. Sensor arrangement according to one of claims 1 to 7, wherein the flexible printed circuit board (41) is bent substantially into a tube or a tube segment, wherein at least two opposing actuation sections (13) for generating a magnetic field (M) are arranged on the flexible printed circuit board (41), wherein at least two sensor sections (11) for measuring a Hall voltage (U) are provided, rotated by 90° relative to the actuation sections (13) about a flow direction (S).

9. Sensor arrangement according to one of claims 1 to 8, wherein the flexible printed circuit board (41) and the rigid printed circuit board (42) are mechanically and electrically connected to one another by a connecting section (14), wherein the connecting section (14) is configured to be flexible or rigid.

10. Fluid system (100) having at least one flowing fluid (F) which flows through a fluid channel (110) with a flow direction (S), and having at least one sensor arrangement (10) according to one of the preceding claims, wherein the flexible printed circuit board (41) of the sensor arrangement (10) is arranged, at least in some regions, within the fluid channel (110).

## Revendications

1. Dispositif de capteurs (10), comprenant une section de capteur (11) comportant au moins un capteur (21) et comprenant au moins une section électronique (12) comportant un circuit électronique (22) destiné à commander et/ou à lire ledit au moins un capteur (21), ledit au moins un capteur (21) étant relié électriquement à ladite au moins une électronique (22), la section électronique (12) étant disposée sur une carte de circuit imprimé rigide (42), et la section de capteur (11) étant disposée sur une carte de circuit imprimé flexible (41) ou étant réalisée sous la forme d'une carte de circuit imprimé flexible (41),
**caractérisé en ce que**
le dispositif de capteurs (10) comporte au moins une section d'action (13) qui est disposée à proximité de l'au moins une section de capteur (11), l'au moins une section d'action (13) étant conçue comme un élément chauffant électrique (23), l'électronique (22) est agencée pour commander l'élément chauffant électrique (23) en continu, par intermittence ou de manière cadencée.

2. Dispositif de capteurs selon la revendication 1, dans lequel l'au moins une section d'action (13) est conçue sous la forme d'un élément chauffant électrique (23) et d'au moins une bobine (34) destinée à générer un champ magnétique, le circuit électronique (22) étant agencé pour commander l'élément chauffant électrique (23) et l'au moins une bobine (34) de manière continue, intermittente ou cadencée.

3. Dispositif de capteurs selon la revendication 2, dans lequel l'au moins une section d'action (13) est intégrée dans la carte de circuit imprimé flexible (41) à côté de la section de capteur (11); ou plusieurs sections d'action (13) sont intégrées en alternance avec plusieurs sections de capteur (11) dans la carte de circuit imprimé flexible (41) ou sont disposées sur la carte de circuit imprimé flexible (41).

4. Dispositif de capteurs selon l'une des revendications 1 à 3, dans lequel l'au moins un capteur (21) est conçu comme un capteur capacitif, comme un capteur résistif, comme au moins une électrode de capteur et/ou comme un capteur de conductivité.

5. Dispositif de capteurs selon l'une des revendications 1 à 4, dans lequel la carte de circuit imprimé flexible (41) est enroulée en spirale ou en tube.

6. Dispositif de capteurs selon l'une des revendications 1 à 5, dans lequel la carte de circuit imprimé flexible (41) comporte une structure de renfort (43) et/ou des éléments d'écartement (44) qui sont agencés pour maintenir la carte de circuit imprimé flexible (41) sous une forme courbée et/ou enroulée.

7. Dispositif de capteurs selon l'une des revendications 1 à 6, dans lequel la carte de circuit imprimé flexible (41) est agencée pour être disposée à l'intérieur d'un fluide (F) présentant une direction d'écoulement (S), la carte de circuit imprimé flexible (41) pouvant être orientée de telle sorte que la direction d'écoulement (S) s'étende parallèlement à une extension plane de la carte de circuit imprimé flexible (41).

8. Dispositif de capteurs selon l'une des revendications 1 à 7, dans lequel la carte de circuit imprimé flexible (41) est courbée pour former essentiellement un tube ou un segment de tube, au moins deux sections d'action (13) opposées l'une à l'autre, destinées à générer un champ magnétique (M), étant disposées sur la carte de circuit imprimé flexible (41), et dans lequel au moins deux sections de capteur (11) destinées à mesurer une tension de Hall (U) sont prévues, tournées de 90° par rapport aux sections d'action (13) autour d'une direction d'écoulement (S).

9. Dispositif de capteurs selon l'une des revendications 1 à 8, dans lequel la carte de circuit imprimé flexible (41) et la carte de circuit imprimé rigide (42) sont reliées mécaniquement et électriquement l'une à l'autre par une section de liaison (14), la section de liaison (14) étant de conception flexible ou rigide.

10. Système fluidique (100) comprenant au moins un fluide en écoulement (F) qui s'écoule à travers un canal de fluide (110) selon une direction d'écoulement (S), et comprenant au moins un dispositif de capteurs (10) selon l'une des revendications précédentes, la carte de circuit imprimé flexible (41) du dispositif de capteurs (10) étant disposée, au moins par zones, à l'intérieur du canal de fluide (110).
